Europäisches Patentamt

European Patent Office

Office européen des brevets

(19)

(11) Publication number: **0 413 479 A1**

# (12) EUROPEAN PATENT APPLICATION

(21) Application number: **90308513.2**

(22) Date of filing: **02.08.90**

(51) Int. Cl.5: **H01L 29/73, H01L 29/08**

(30) Priority: **14.08.89 US 393611**

(43) Date of publication of application:
**20.02.91 Bulletin 91/08**

(84) Designated Contracting States:
**DE FR GB IT**

(71) Applicant: **DELCO ELECTRONICS CORPORATION**
**700 East Firmin Street**
**Kokomo Indiana 46902(US)**

(72) Inventor: **Gose, Mark Wendell**
**722 South 400 East**
**Kokomo, IN 46902(US)**
Inventor: **LaRosa, David Andrew**
**301 Cypress Court**
**Kokomo, IN 46902(US)**
Inventor: **Dinkledine, Thomas L.**
**11350 West 100 South**
**Russiaville, IN 46979(US)**

(74) Representative: **Haines, Arthur Donald et al**
**Patent Section Vauxhall Motors Limited 1st**
**Floor Gideon House 26 Chapel Street**
**Luton, Bedfordshire LU1 2SE(GB)**

(54) Uniform temperature power transistor.

(57) Hot spots in a semi-conductor integrated circuit (240) containing one or more multi-emitter power transistors (21,22,23) are avoided by providing a ballast resistor (26b) in series with each emitter (28a,28b) and proportioning the resistances of all ballast resistors so that the operating temperature at each of the emitters (28a,28b) of each transistor (21,22,23) is substantially equal to the average operating temperature of that transistor (21,22,23). Electro-thermal modelling techniques are disclosed for permitting the emitter/ballast resistor proportioning to be accomplished with the aid of a computer.

EP 0 413 479 A1

FIG. 2

# UNIFORM TEMPERATURE POWER TRANSISTOR

### Field of the Invention

This invention relates generally to an integrated circuit (IC) and, more particularly, to an IC that includes at least one power bipolar junction transistor (BJT).

### Background of the Invention

A power BJT poses special problems because of the high power generated which results in portions of the IC (e.g., semi-conductor chip or body or substrate) having undesirably high temperatures. Accordingly, it has been recognized that it is helpful to divide the emitter of a power BJT into individual segments and to operate them in parallel in order to increase emitter efficiency and to limit concentrations of heat. Power BJTs tend to exhibit defects known as "hot spots," each of which is caused by runaway current resulting from positive thermal feedback effects at individual emitter segments. BJTs have an unfortunate tendency, therefore, to burn out at regions adjacent such emitter segments.

Various approaches have been used to overcome the problem of hot spots. One approach is taught in U.S. Patent No.4,072,979, which issued February 7, 1978, to S. Palara. This approach places a separate ballast resistor in series with each emitter segment to limit the current flow in each associated transistor segment and tailors each ballast resistor to its individual segment in an attempt to provide substantially equal current flow in all segments. In particular, each ballast resistor is proportioned inversely with the distance of its particular emitter segment from an emitter bus which connects the emitters together electrically. In this way, the lower effective emitter voltages available at the more distant emitter segments are compensated for because of the higher voltage drops resulting from the longer paths. Unfortunately, however, hot spots still tend to persist and transistor power capacity remains unnecessarily limited.

U.S. Patent No.4,682,197 (F. Villa et al.), issued July 21, 1987, describes various power transistors which have separate uniformly spaced-apart base regions which are each coupled to one of a plurality of essentially identical base drive circuits. Each of the base regions receives an essentially equal base drive current such that the possibility of one base region and its associated emitter(s) drawing more current than the others is limited. This approach, like that of the previously described U.S.

Patent 4,072,979, attempts to provide substantially equal current flow in all segments of a power transistor. This still allows hot spots to exist which limit transistor capacity.

A different approach to the hot spot problem is exemplified by the disclosure in U.S. Patent No.3,704,398, which issued November 28, 1972, to K. Fukino. Fukino suggests that, in a power BJT having segmented (multiple) emitters, achieving a uniform distribution of junction temperatures is preferable to achieving a uniform distribution of junction currents. It is noted, moreover, that the collector portions at the central area of such a transistor tend to experience higher temperature rises due to the heat flow from adjacent collector portions than do the collector portions nearer the periphery where the divergence of heat flow is greater. It is, therefore, concluded that the workable operating limit of the transistor is governed primarily by the junction temperature of the central area. Accordingly, to increase the power capacity of a BJT, Fukino proposes that the intervals between adjacent emitter segments in the central portion of a semi-conductor chip be made relatively wide, whilst the intervals between adjacent emitter segments are made progressively more narrow as their locations approach the peripheral portion of the semi-conductor chip. All the divided elemental segments are thus made to operate at substantially the same junction temperature at a predetermined transistor power level. One serious problem with the Fukino concept is that it tends to increase chip area and, therefore, increases the cost of manufacture.

It is desirable to have an IC in which hot spots are essentially eliminated or reduced in number and which occupies as small a chip area as reasonably possible.

### Summary of the Invention

Viewed from one aspect, the present invention is directed to a semi-conductor body (substrate) comprising at least one device which (1) has a plurality of essentially equally-spaced portions which each, during operation of the device, dissipate power, and (2) has means for controlling power dissipation of each portion of the device, effective to make the temperature of each portion of the device essentially the same at a predetermined overall current flow.

In one typical embodiment, the power device is formed in a silicon substrate and comprises a part of an integrated circuit. The device is a multi-emitter power bipolar junction transistor with each emitter having a ballast resistor effectively in series therewith. The value of the resistance of each resistor is selected so as to determine the amount of current which will flow through that resistor and the emitter associated therewith during operation of the device. This controls the power dissipation in each emitter-ballast resistor combination. The value of the resistance of each resistor is determined by taking into account the position of the emitter relative to other emitters and relative to other power-dissipating (heat-generating) devices on the substrate and the heat-dissipating capability of the portion of the substrate containing the emitter so as to result in the temperature of all emitter-ballast resistor combinations being essentially the same during operation of the transistor. This helps eliminate hot spots on the substrate body and thus helps ensure against a failure of the transistor. A substrate with a transistor and/or other components thereon may be denoted as an integrated circuit (IC).

One general principle of the present invention is that the resistance of each emitter ballast resistor of a transistor on a chip is selected by (1) determining the location of that emitter-ballast resistor combination on the chip, (2) determining the heat-dissipating capabilities of that portion of the chip, and (3) determining what, if any, other heat-generating components are around each emitter-ballast resistor combination.

With a single multi-emitter transistor occupying the entire chip, typically the resistance of the ballast resistors are proportioned in relation to each other so that ballast resistances on interior portions of the semiconductor body surface are typically larger than those closer to the body perimeter. In this manner, current levels are limited more in those emitters occupying space where heat dissipation is more difficult and high packing densities can be maintained. It is noted that this relationship is essentially the inverse of that taught by U.S. Patent 4,072,979, which seeks to equalize emitter currents.

For complex chip structures with substantial numbers of heat-generating elements, a reasonable degree of temperature uniformity over each transistor can be achieved by using computer techniques of the type to be disclosed herein below. An example of commercially-available models of transistors is given in the article, "Spice Extensions Dynamically Model Thermal Properties," by Eric Filseth and Mike Jachowski, which was published April 14, 1988, in the magazine EDN.

Yet another aspect of the invention is directed to a method of semi-conductor chip design using such techniques, in which for each element (component) (e.g., transistor, circuit, device, etc.)

on the chip, power dissipation is modelled as an electrical current, temperature is modelled as a voltage, and thermal impedance is modelled as a resistance in parallel with a capacitance. The average temperature of a multi-emitter power transistor is measured and each emitter ballast resistor has its resistance adjusted interactively until the temperature at all of the multi-emitters is substantially equal to the average temperature of the transistor.

The invention will be better understood from the following more detailed description, taken in the light of the accompanying drawing and appended claims.

Brief Description of the Drawing

Figure 1 is a schematic diagram of a power bipolar junction transistor in accordance with the present invention;

Figure 2 illustrates a layout of the emitter areas of a power bipolar junction transistor in accordance with the present invention;

Figure 3A shows a thermal analogue of a semiconductor integrated circuit;

Figure 3B shows an electrical analogue of Figure 3A;

Figure 4A is a graphic view of a silicon die;

Figure 4B shows a thermal resistance network representing a portion of the silicon die in Figure 4A;

Figure 5A shows an example of a partition of the silicon die shown in Figure 4A;

Figure 5B shows an electrical network constituting a thermal map of Figure 5A;

Figure 6 is an electro-thermal model of a resistor;

Figure 7 is a block diagram of an electro-thermal resistor;

Figure 8 is an electro-thermal transistor symbol;

Figure 9 is a block diagram of an electro-thermal n-p-n transistor;

Figure 10 is an electro-thermal ballast averaging resistance symbol;

Figure 11 is a block diagram of an electro-thermal ballast averaging resistance;

Figure 12 is a schematic diagram of a normal electro-thermal circuit; and

Figure 13 is a schematic diagram of an electro-thermal circuit used to achieve uniform temperature distribution in a semi-conductor chip containing one or more power bipolar junction transistors in accordance with the present invention.

It is to be noted that the figures of the drawings are not necessarily drawn to scale.

Detailed Description

A power bipolar junction transistor (BJT) in accordance with the present invention is a transistor whose emitter is divided into an array of segments and which includes a particular amount of series ballast resistance in the current path of each emitter segment. Such a transistor is also known as a multi-emitter power transistor. In an illustrative embodiment to be discussed, the transistor is generally of the kind described in the above-identified U.S. Patent 4,072,979, to which reference may be made for a more detailed description of its general structure and manner of preparation.

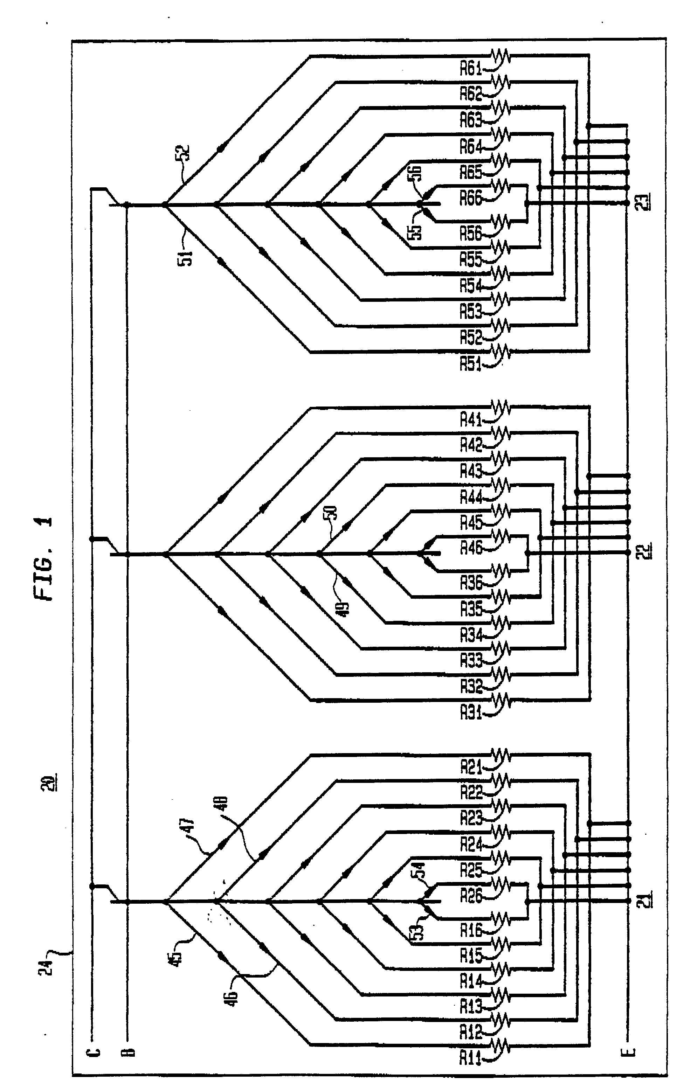

Referring now to Figure 1, there is shown a schematic diagram of an approximate equivalent electrical circuit of a single n-p-n Bipolar Junction Transistor (BJT) 20 in accordance with the present invention. For illustrative purposes, BJT 20 is shown as the only component on a semi-conductor chip 24. BJT 20 is a multi-emitter transistor which comprises individual transistor segments 21, 22, and 23 that are shown occupying positions relative to one another roughly analogous to positions occupied on the semi-conductor chip 24. BJT 20 could also be a multi-emitter p-n-p transistor. In many applications BJT 20 is just one of several or many components, devices, circuits, etc., some of which may also be power transistors, formed on a chip 24.

A base bus B, an emitter bus E, and a collector bus C are shown as common to the transistor segments 21, 22 and 23. In this illustrative example, the transistor 20 is divided into three parallel columns, with transistor segment 21 occupying the first column, transistor segment 22 occupying the second column and transistor segment 23 occupying the third column. Each of the three columns has its emitter subdivided into parallel segments, of which 45, 46, 47, 48, 49, 50, 51, 52, 53, 54, 55 and 56 are examples. Each emitter segment, in turn, has its own individual series ballast resistor connected from it to the common emitter bus E. The left-hand side of transistor segment 21 has associated ballast resistors R11 to R16, whilst the right-hand side has associated ballast resistors R21 to R26. Each pair of adjacent emitter segments, such as 53 and 54, share a common emitter electrode which is coupled to the emitter bus E. The ballast resistors are shown integral to each emitter segment but they could be separate resistors.

Although Figure 1 is by no means drawn to scale, it is intended that the emitter segments to which ballast resistors R11 to R16 are connected are nearer the periphery of chip 24 than are those to which ballast resistors R22 to R25 are connected. Amongst the emitter segments to which ballast resistors R11 to R16 are connected, those associated with ballast resistors R11 and R16 are nearest to left-hand corners of chip 24, with the others following in sequence.

The layout of the remainder of Figure 1 is similar to that already described. Transistor segment 23 is substantially a mirror image of segment 21, with the emitter segments associated with ballast resistors R61 to R66 on the outside on the right and those associated with ballast resistors R51 to R56 on the interior on the left. Transistor segment 22 is located between segments 21 and 23, and the emitter segments associated with ballast resistors R31 to R36 are like those associated with ballast resistors R41 to R46, with substantial symmetry from left to right. As shown, the emitter segments 45 and 52, which are close to the top of Figure 1, are nearer the periphery of chip 24 than are emitter segments 49 and 50, which are nearer the centre of chip 24. Similarly, the emitter segments 53 and 56, which are close to the bottom of Figure 1, are nearer the periphery of chip 24 than are emitter segments 49 and 50, which are nearer the centre of chip 24.

In the past, transistors of this general type have usually been operated with either a substantially uniform current distribution (as in U.S. Patent 4,072,979) or a substantially uniform power dissipation across the structure of the device. Neither really comes to grips with the problem of reducing undesirable and potentially destructive hot spots (i.e., high-temperature areas) which can result in failure of the transistor 20. The U.S. Patent 3,704,398 discloses the avoidance of hot spots by spreading out the emitter segments so that they are more distant from one another at central portions of the semi-conductor chip than at or near the periphery. This concept tends to result in unused chip area, which adds to chip cost. The present invention solves the problem in transistor 20 and permits retention of high packing densities by operating the transistor 20 with a substantially uniform temperature distribution, as opposed to either uniform current or uniform power distribution. When transistor 20 is a part of an IC in which the other components do not generate relatively much heat, the heat dissipation from these areas permits the transistor 20 to be operated at a higher average temperature.

One general principle of the present invention is that the resistance of each of the emitter ballast resistors of a transistor on a chip is selected by determining the location of each of the emitter-ballast resistor combinations on the chip, determining the heat-dissipating capabilities of that portion of the chip and determining what, if any, other heat-generating components are around each emitter-ballast resistor combination.

In BJT 20 the resistance of the ballast resistors associated with emitter segments (e.g., 49 and 50) at interior portions of chip 24 is greater than the resistance of those ballast resistors associated with emitter segments (e.g., 45 and 52) nearer the periphery of the chip 24. On semi-conductor chip 24, emitter ballast resistors R11, R16, R61, and R66 have the smallest resistance of all. This is because they are located at the four corners of the chip 24 where there are no other heating generating components on two sides of each of them. On the left-hand periphery of chip 24, resistors R12 and R15 have a somewhat larger resistance than R11 and R16, and resistors R13 and R14 have a somewhat larger resistance yet again. On the upper periphery of chip 24, resistors R21 and R51 have a somewhat larger resistance thzn R11 and R61, and resistors R31 and R41 have a somewhat larger resistance yet again. The same pattern continues in the interior portions of chip 24, where ballast resistors R23 and R53 have a somewhat smaller resistance than ballast resistors R33 and R43. Because their emitter segments are surrounded on all sides by the maximum number of heat-generating elements and because heat dissipation there is least, ballast resistors R33, R34, R43, and R44 have the greatest resistance values of all in this illustrated embodiment of the invention. The greater the resistance of the ballast resistor, the smaller the current flow through the corresponding emitter segment.

Although the present invention may be employed to advantage without optimization, the greatest benefits are typically realized when the resistance of each emitter ballast resistor is chosen so that the temperature at its corresponding emitter segment when the transistor is in operation is substantially equal to the average temperature of that transistor. For the embodiment illustrated in Figure 1, the resistance of each of the ballast resistors R11 to R16, R21 to R26, R31 to R36, R41 to R46, R51 to R56, and R61 to R66, is selected in this manner.

For chip structures that are more complex than chip 24, the same basic principles apply, whether the chip contains multiple other components, circuits, devices, etc., and/or power transistors.

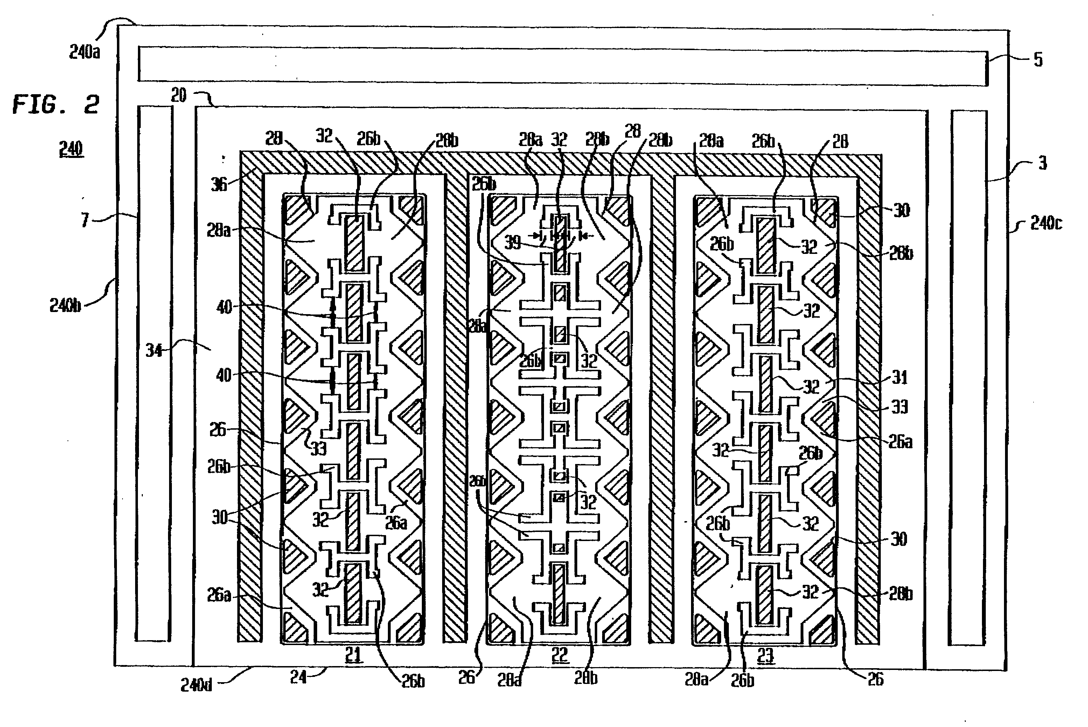

Referring now to Figure 2, there is shown a semi-conductor chip 240 which has sides 240a, 240b, 240c and 240d and is in accordance with the present invention. Chip 240 comprises a segmented power BJT 20 of the type illustrated schematically in Figure 1 and three circuits 3, 5 and 7 which are typically of lower power dissipation than transistor 20. Accordingly, circuits 3, 5 and 7 generate less heat than does transistor 20. A top side, a bottom side, a right-hand side and a left side of transistor 20 face circuit 5, side 240d of chip 240, circuit 3 and circuit 7, respectively.

Transistor 20 comprises three transistor segments 21, 22, and 23. A collector region 34 is common to all of the transistor segments 21, 22 and 23. Collector region 34 has a contact area 36 that allows electrical contact to a collector bus (not shown). Each of the transistor segments 21, 22 and 23 has a separate base region (area) 26 having base contact regions 30 and has in a portion thereof an emitter region (area) 28 having emitter contact regions 32. Portions 26b of base region 26, which are H-like members or portions of H-like members, partly surround a portion of six separated emitter contact areas 32 of each of the segments 21 and 23 and partly surround a portion of each of ten separated emitter contact areas 32 of segment 22. The H-like members 26b of transistor segments 21 and 23 serve to effectively divide each emitter region 28 of transistor segments 21 and 23 into twelve emitter segments arranged in two vertical columns of six 28a segments and six 28b segments. The H-like members 26b of transistor segment 22 serve to effectively divide each emitter region 28 of transistor segment 22 into sixteen emitter segments arranged in two vertical columns of eight 28a segments and eight 28b segments. To simplify the drawing, metallizations (i.e., metal contact areas) to emitter contact regions 32, base contact regions 30 and collector contact region 36 are not shown. Each of the emitter contact areas 32 permits a separate pair of emitter segments 28a and 28b to be connected via metallization to an emitter bus (not shown and typically running horizontally with respect to the emitter contact regions 32 of each of the transistor segments 21, 22 and 23). Metallization (not shown) serially connects the base regions 26 of each of the transistor segments 21, 22 and 23 to a base bus (not shown). Electrical contact from collector contact region 36 to a collector bus (not shown) is typically made by way of metallization (not shown) running along the top and right-hand sides of Figure 2 and extending between respective transistor segments 21, 22, and 23. In some applications, the collector bus also runs along the left-hand side of Figure 2.

The geometrical shape of the portion of each emitter segment constricted by the whole or partial H-shaped base areas 26b in Figure 2 largely determines the amount of resistance of the ballast resistor associated with that emitter segment. For equal horizontal lengths 39, the constricted portions having less vertical widths 40 have more resistance than do those with greater vertical widths 40. For equal vertical widths 40, those with greater horizontal lengths 39 have more resistance. In general, more constricted areas in the emitter segment typically afford greater amounts of associated emitter ballast resistance. Less constricted areas, on the other hand, typically mean less emitter ballast resistance. The emitter contact areas 32 have an additional influence upon the size and, therefore, resistance of each ballast resistor. Where, particularly in the interior regions of chip 24, the emitter contact areas 32 are smaller, those smaller contact areas 32 result in greater series emitter resistance because they effectively add emitter area which adds to the total amount of ballast resistance associated with their particular emitter segment.

Left-hand transistor segment 21 and right-hand segment 23 are essentially mirror images of one another. The resistances of emitter ballast resistors in the emitter segments 28a of transistors 21 and 23 nearest side 240a of chip 240, where heat-dissipation is best, are the smallest. The resistances of emitter ballast resistors close to the centre of emitter segment 22 are the highest since there are the greatest number of heat-generating components surrounding these resistors. Functionally, the larger resistances limit emitter current more than do smaller resistances, with the result being that less heat is generated at their emitter sites.

A substantially uniform packing density is retained within the power transistor 20 on the chip 240 and the highest resistance emitter ballast resistors, represented by the narrowest of horizontal lengths 39, are at positions on the chip 240 where the operating temperatures would otherwise be greatest. The lowest resistance emitter ballast resistors, represented by the widest of vertical widths 40, permit larger emitter currents and are at positions on the chip 240 where the operating temperatures would otherwise be least. To obtain a substantially uniform operating temperature across the power transistor 20, each horizontal length 39 and vertical width 40 is selected to result in a resistance which controls current flow so that the operating temperature at that particular pair of emitter segment areas 28a and 28b is as nearly as possible equal to the average operating temperature of the power transistor 20. In the case where a plurality of multi-emitter power transistors essentially surround a central multi-emitter power transistor, the resistors of outer emitters of the central transistor may have similar resistor proportions as would be found at or near the centre of a single transistor.

It is entirely feasible to derive a suitable set of resistance values for the emitter ballast resistors intuitively or by trial and error using the basic principles taught herein. It is particularly advantageous, however, in accordance with another aspect of the invention, to use computer techniques and derive the resistance values by modelling heat dissipation as an electrical current, temperature as a voltage, and thermal impedance as a resistance in parallel with a capacitance. Such techniques are described in the previously mentioned article, "Spice Extensions Dynamically Model Thermal Properties," in the book, Thermal Analysis and Control of Electronic Equipment ," by Kraus and Bar-Cohen, published in 1983 in New York by the Hemisphere Publishing Corporation, and are expanded upon in the accompanying appendix, which is incorporated herein.

It is to be understood that the embodiments which have been described are illustrative. Modifications may readily be devised by those skilled in the art without departing from the scope of the invention claimed. For example, the transistor 20 of Figure 1 can be modified so that the base areas are not electrically connected together. Accordingly, a separate base drive can be connected to each base so as to control power dissipation in each base and the associated emitter(s) and resistor(s) associated therewith. Still further, the transistor of Figure 1 can be modified so that each of the transistor segments 21, 22 and 23 has a separate collector which is connectable to a separate voltage source. In this modification the magnitude of the voltage of each of the separate voltage sources can be varied so as to control power dissipation through each of the transistors segments so as to keep the temperature of each of the transistor segments fairly equal. Still further, the multi-emitter structure of Figure 1 can be achieved with a number of structures other than the one shown in Figure 2. One example is a bipolar transistor having a base area in which there are a plurality of multiple emitter regions which each have their own separate emitter contact area and which are separated from each other by portions of the base region. Still further, in some chips which contain power transistors and other devices which dissipate less power, there may be portions of the chip which are higher in temperature than the average temperature of the chip, but the temperature within the portions of the chip which contain the power transistors can be kept relatively constant.

From the foregoing, one can see that the invention involves considering the power transistor dynamically at its intended operating overall current flow, or intended operating power level. Heat generated, i.e., the rate of heating is balanced with the rate of cooling at a predetermined operating level. It is balanced in as many small segments as is practical, to avoid hot spots. Using this technique, the segments can be closely packed and operated at a high operating power level.

APPENDIX

Electro-Thermal Basics

When an electrical device dissipates power, self-heating occurs. The amount of self-heating depends on the physical system surrounding the device. The physical system for a semi-conductor integrated circuit depends on the material used (typically silicon) and the location of devices with respect to each other.

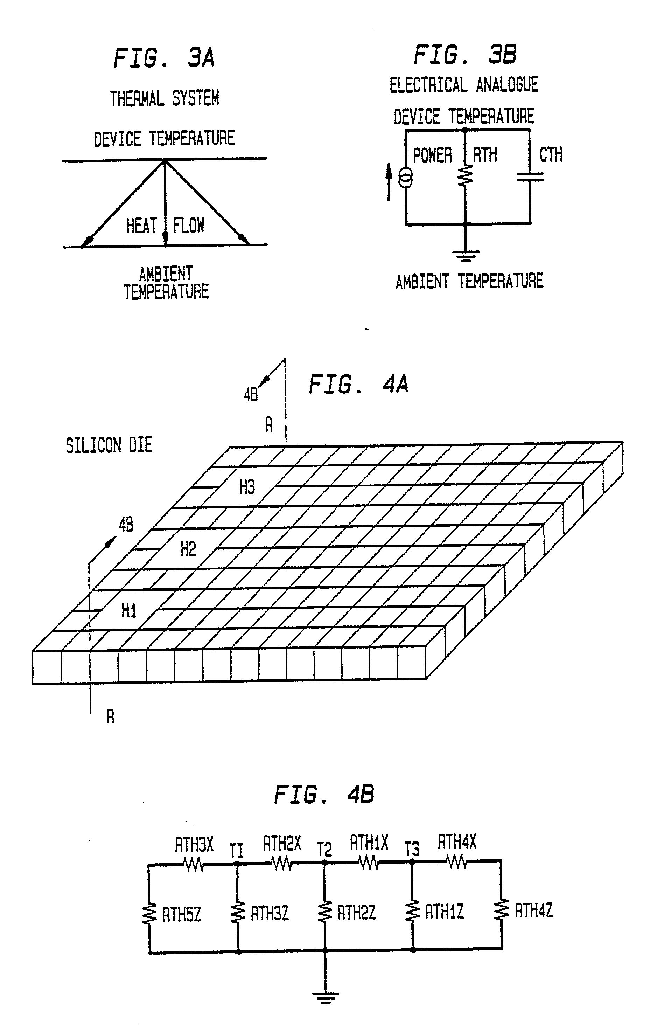

A thermal analogue of such a system is shown in Figure 3A, representing a piece of silicon with a heat source located at the top. The heat generated flows through the material to reach ambient conditions. This causes the temperature of the device to rise. The equation describing such a system is:

q = T/Rth

where q is heat flow in watts, T is the change in temperature across the material in degrees Centigrade, and Rth is thermal resistance in degrees Centigrade per watt.

The thermal system of Figure 3A can be modelled by the electrical circuit shown in Figure 3B, and the governing equation is:

I = V/R

where I is current in amperes, V is the change in voltage across R in volts, and R is electrical resistance in ohms. As has already been stated, the thermal heat flow is modelled as an electrical current, the thermal temperature is modelled as an electrical voltage, and the thermal impedance is modelled as an electrical resistance in parallel with a capacitance.

In Figures 3A and 3B, it is important to note that the heat flow q is generated by an electrical device. The heat flow is the equivalent of the power dissipated by that device, which is why the current source in Figure 3B is labelled POWER. This means that there is another electrical circuit somewhere on the semi-conductor chip that has a device dissipating a POWER.

Thermal Resistance of an Integrated Circuit

This section describes how a network of thermal resistors can be used to describe a physical system. The particular physical system of interest is a silicon integrated circuit. The example chosen has three transistors on it as heat sources. A graphic view of a silicon die is shown in Figure 4A. This graphic view represents the physical system of present interest. The die is subdivided into volumes that relate to devices on the surface. Three heaters H1, H2, and H3 or devices dissipating power are shown. These heaters are operating at the respective temperatures T1, T2, and T3. If the die is modelled in two dimensions along the plane A-A in Figure 4A, the simpler thermal resistance network shown in Figure 4B can be derived.

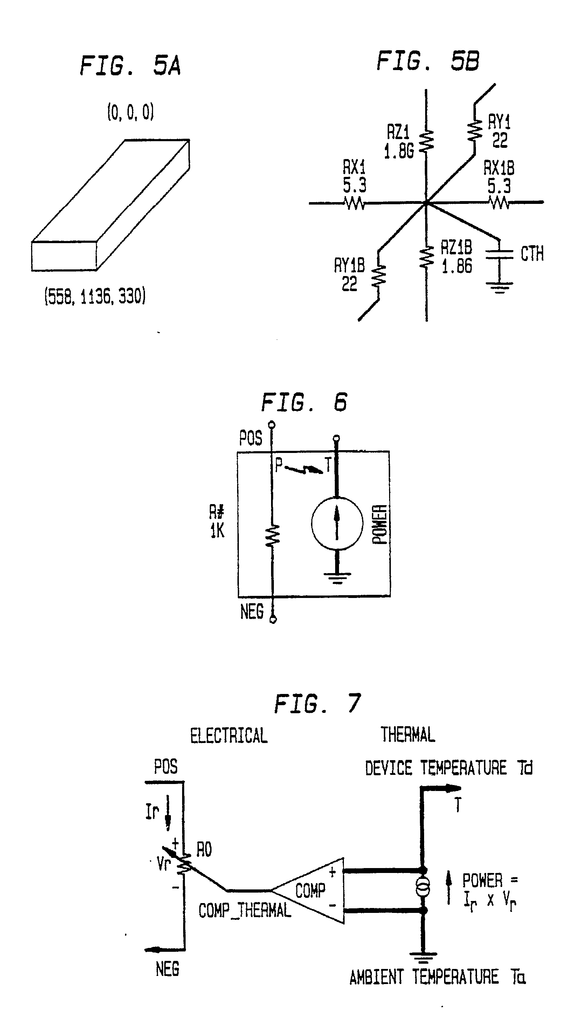

Once the die has been partitioned, each partition can have a thermal impedance associated with it. Figure 5A shows an example of such a partition and Figure 5B shows the electrical network associated with it as an individual thermal map. A network for each partitioned volume is then interconnected to form a thermal impedance map of the total silicon die. For a large die and complicated circuit, there can easily be over a thousand thermal resistors in the thermal map alone. For ease of discussion, though, the simple nine resistor network in Figure 4B is used in this document. The equation for the thermal resistance of this volume is:

RTH = Thickness/(Area normal to flow x Material constant)

Electro-Thermal Device Models

This section gives a simple description of the three device models used for electro-thermal simulations. In the interest of simplicity, the following convention is used in all of the schematic diagrams henceforth referred to: (1) all electrical components are drawn on the left side under the word ELECTRICAL; (2) all thermal components are drawn on the right side under the word THERMAL with a heavier line than the electrical components; and (3) the crooked arrow symbol pointing from P to T signifies that the electrical parameter power is being transformed into the thermal parameter temperature.

Resistor Model

Figure 6 shows a symbol of an electro-thermal resistor. This device has three terminals: POS, NEG, and T. The electrical resistance is between POS and NEG. A thermal heat flow generator is connected between thermal "ground" (i.e., ambient temperature) and terminal T. Terminal T is where an external thermal resistance is connected to cause a temperature rise at terminal T.

Figure 7 is a diagram demonstrating what is taking place inside the symbol of Figure 6. An electrical resistor R0 has current Ir through it and voltage Vr across it. R0 dissipates a power equal to Ir times Vr. This power is the value of a thermal heat flow (electrical current source) connected between the ambient surroundings and terminal T.

Comp-Thermal is a comparator that has two temperatures as inputs and an electrical output. The two temperatures are the device temperature Td and ambient temperature Ta. The temperature difference is input to the comparator, which adjusts the resistor value R according to the following equation:

R = R0[1 + TC( Td - Ta)]

where TC is the temperature coefficient in ohms per degree Centigrade and RO is the ohmic. value at temperature Ta.

## Transistor Model

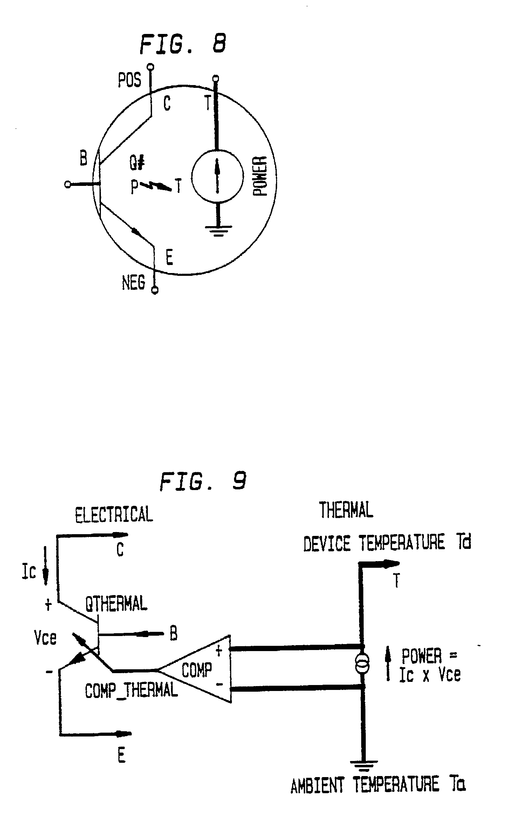

The symbol of an electro-thermal transistor is shown in Figure 8. This device has four terminals B, C, E, and T. The electrical transistor is connected to terminals B, C, and E. A thermal heat flow generator is connected between thermal "ground" (i.e., ambient temperature) and terminal T. Terminal T is where an external thermal resistance is connected to cause a temperature rise at terminal T.

Figure 9 is a diagram showing what is taking place inside the symbol of Figure 8. An electrical transistor Qthermal has current Ic through it and voltage Vce between its emitter and collector terminals. Qthermal dissipates a power equal to Ic times Vce (neglecting the power in the Base, Ib times Vbe, which is small). This power is the value of a thermal heat flow (electrical current source) connected between ambient and node T.

Comp-Thermal is a comparator that has two temperatures as inputs and an electrical output. The two temperatures are the device temperature Td and ambient temperature Ta. The comparator takes the temperature difference and uses the following equation to adjust the Vbe value of the transistor:

$$Vbe = Vbe1[1 + TC(Td - Ta)]$$

where TC is the temperature coefficient in millivolts per degree Centigrade and Vbe1 is the emitter-base voltage at temperature Ta and current Ic. While all the transistor temperature parameters vary with temperature, the parameter most affected by temperature changes is the base to emitter voltage, Vbe.

## Temperature Averaging Resistor Model

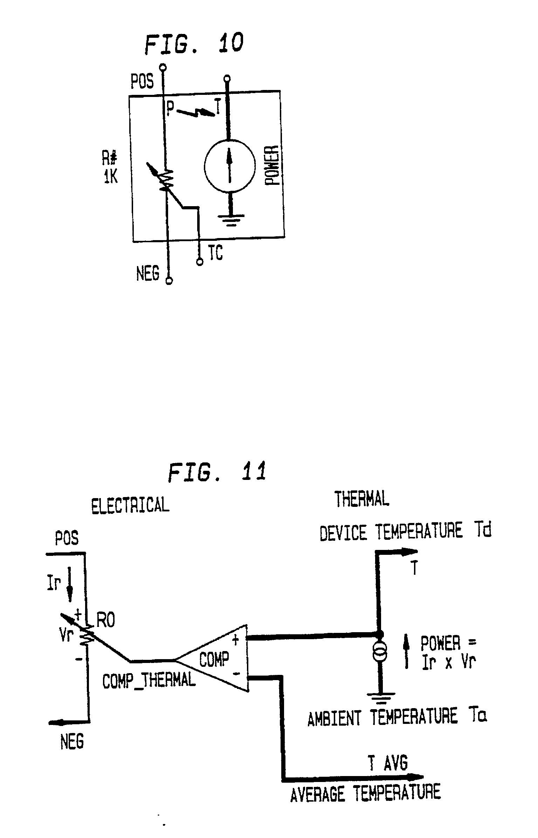

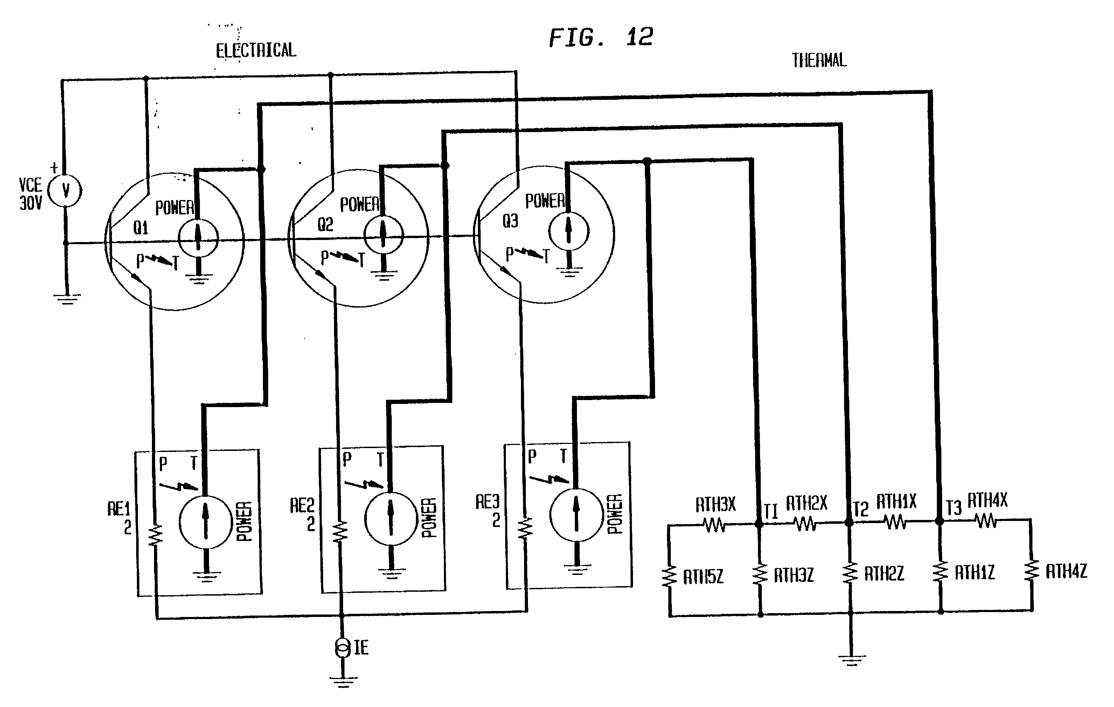

Figure 10 is the symbol for an electro-thermal averaging resistor. This device has four terminals POS, NEG, T, and TC. The electrical resistance is between POS and NEG. A thermal heat flow generator is connected between thermal "ground" (i.e., ambient temperature) and terminal T. Terminal T is where an external thermal resistance is connected to cause a temperature rise at node T. TC is a thermal terminal which is connected to the desired controlling temperature. Figure 11 is a diagram showing what is taking place inside the symbol of Figure 10. An electrical resistor R0 has current Ir through it and voltage Vr across it. R0 dissipates a power equal to Ir times Vr. This power is the value of a thermal heat flow (electrical current source) connected between ambient temperature Ta and node T.

Comp-Thermal is a comparator that has two temperatures as inputs and an electrical output. The two temperatures are the device temperature Td and an average temperature Tavg. Tavg is the average temperature calculated externally. The comparator takes the temperature difference and adjusts the resistor value R. After the simulation is over, the temperature corrected value of R is calculated:

$$R = Vr/\{Ir[1 + TC(Td - Ta)]\}$$

where TC is the temperature coefficient in ohms per degree Centigrade.

## Basic Simulation Method

This section describes the basic electro-thermal simulation technique for a uniform temperature power transistor. This simulation may be done by hand, but using a computer is typically much faster.

Figure 12 is a schematic diagram representing both electrical and thermal circuits. Q1, Q2, and Q3 are the heaters shown in Figure 4B. RE1, RE2, and RE3 are emitter degeneration resistors that are embedded in devices Q1, Q2, and Q3, respectively. In other words, RE1 and Q1 have the same physical location, and so on. RTH1X to RTH4X and RTH1Z to RTH5Z are thermal resistors representing the physical system of the total silicon die shown in Figure 4A.

The method for solving this system is straightforward and includes the following steps:

1. Use ambient temperature., Vce, Ie and the electrical device parameters to solve the electrical circuit.

2. Calculate the power dissipated in each device.

3. Solve the thermal circuit using power and the thermal impedances.

4. Compare T1, T2, and T3. If they are not the same, adjust values of RE1, RE2, and RE3 and start analysis again at step 1.

The above example is for illustration. To obtain a high resolution of temperature, a fine grid is used for the thermal resistors (see Figure 4B). Also, each transistor can be broken up into smaller transistors. This large circuit then can be used with a simulator like the one described in the previously identified article, "Spice Extensions Dynamically Model Thermal Properties," by Filseth and Jachowski, published April 14, 1988, in EDN.

It is important to note that there is an inherent interaction or feedback in a simulation of this kind. It was outlined in the steps listed above and will now be described more explicitly. The steps involving thermal feedback include:

A. The electrical system generates a power.

B. This power is transformed into a heat flow.

C. The heat flow causes device temperatures to rise in the thermal system.

D. This temperature rise slightly modifies the electrical system.

E. Is there a stable solution? If not, go to step A. If there is, stop. By a stable solution, what is meant is no change in temperature values between iterations.

The thermal feedback is dependent on the physical system. Again, the physical system is determined by the material used (silicon) and the location of devices with respect to each other.


## Advanced Simulation Technique

This section describes a method of simulation for a uniform temperature power transistor in accordance with the invention. This method controls the thermal feedback to achieve the desired power transistor with uniform temperature.

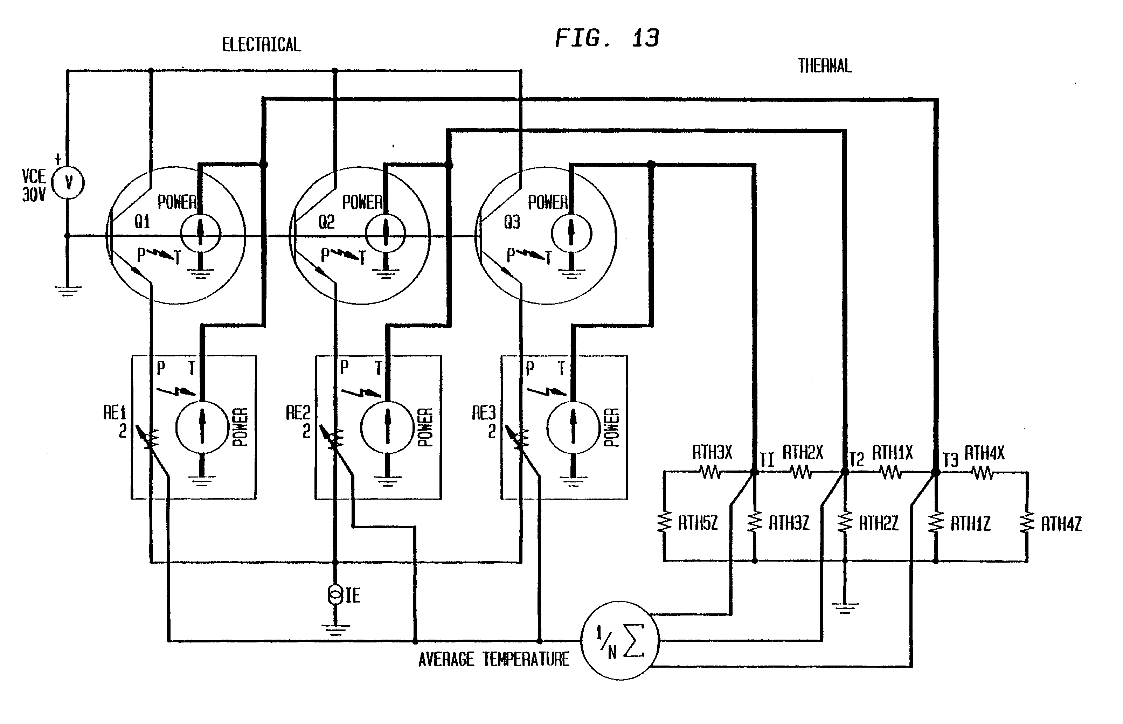

Figure 13 is a schematic diagram representing the same electrical and thermal circuits that were shown in Figure 12. Two circuit components have been added: a temperature averager and an averaging resistor. These components permit automatic calculation of RE1, RE2, and RE3.

The temperature averager (1/N) takes N temperatures and generates their mathematical average. Three temperatures are shown in Figure 13. In a more complicated physical system, there may easily be as many as 18 or more temperatures to average.

The averaging resistor model uses the average temperature to adjust the values of RE1, RE2, and RE3.

A step has been added to the thermal feedback discussed in the last section. The steps involving thermal feedback in this advanced method are:

A. The electrical system generates a power.

B. This power is transformed into a heat flow.

C. The heat flow causes device temperatures to rise in the thermal system.

D. These temperatures are averaged.

E. This average temperature rise slightly modifies the electrical system.

F. Is there a stable solution? If not, go to step A. If there is, stop. By a stable solution, what is meant is no change in temperature values between iterations.

When this circuit is simulated, every device temperature is forced to be the same. After the simulation, resistors RE1, RE2, and RE3 may be calculated using Ohm's law.


## Conclusions

The method of simulation which has been described aids in the design of power transistors which exist on larger monolithic integrated circuits. The method employs a technique which utilizes feedback to solve a complex electro-thermal model for a substantially uniform temperature distribution across the structure under simulation. The specific solution exists in the form of resistor values that, when used as emitter ballast resistors in the power transistor, result in a very nearly uniform temperature distribution across the power transistor. The electro-thermal model is made up of three parts. The first is an electrical circuit which models the performance of the power transistor as an electrical system. The second part of the model simulates the power transistor and its thermal environment as a thermal system with an analogous electrical circuit. The third part of the model is a translation circuit which communicates information between the two systems.

The translation circuit simply acts as a feedback path to the the circuits representing the electrical system and the thermal system together. In the described method, this feedback path is used to adjust the power dissipation in various parts of the electrical circuit to achieve uniform temperature across the power device in the thermal system.


## Claims

1. A semi-conductor body (240) comprising:
at least one device having a plurality of portions (28a,28b), each of which, during operation of the device, dissipates power; and means (26b,32) for controlling the power dissipation of each portion (28a,28b) of the device so that the temperature of each portion (28a,28b) of the device during operation remains essentially the same as the temperature of adjacent portions (28a,28b), characterised in that the portions (28a,28b) are essentially equally spaced from one another, and the means (26b,32) for controlling the power dissipation of each portion (28a,28b) controls the flow of electrical current through that portion (28a,28b).

2. A semi-conductor body (240) according to claim 1, in which the device is a multi-emitter junction transistor (21,22,23) with each emitter (28a,28b) having a resistor (26b) effectively in series therewith.

3. A semi-conductor body (240) according to claim 2, in which the value of each of the resistors (26b) is selected so that, during the operation of the device (21,22,23), power dissipation of each of the emitters (28a,28b) results in each of the emitters (28a,28b) being maintained at essentially the same temperature as all the other emitters (28a,28b) present in the device (21,22,23).

4. A semi-conductor body (240) according to claim 1, in which the device comprises: at least one bipolar junction transistor (21,22,23) having a plurality of essentially equally-spaced emitter segments (28a,28b), each having a separate resistor (26b) coupled thereto; and each of the resistors having a resistance which is selected by determining the location of each emitter-resistor combination on the semi-conductor body, determining the heat-dissipating capabilities of that portion of the semi-conductor body and determining what, if any, other heat-generating components (3,5,7) are around each emitter-resistor combination, so that, during operation of the transistor (21,22,23), the temperature of each emitter segment (28a,28b) is maintained essentially equal to the average temperature of the transistor (21,22,23).

5. A semi-conductor body (240) according to claim 4, in which the transistor (21,22,23) is a multi-emitter n-p-n transistor.

6. A semi-conductor body (240) according to claim 5, in which the semi-conductor body is silicon.

7. A semi-conductor body (240) according to claim 1, comprising transistor (21,22,23) having an emitter (28), a collector (34) and a base (26), said emitter (28) being divided into a plurality of segments (28a,28b) spread substantialy uniformly over at least a portion of the surface of said body with each segment (28a,28b) having a geometrical shape that provides a ballast resistor (26b) in series with that emitter segment (28a,28b), the values of the resistances of the ballast resistors (26b) being proportioned in relation to each other so that ballast resistances on interior portions of the surface of said semi-conductor body are larger than those closer to the semi-conductor body perimeter.

8. A semi-conductor body (240) according to claim 7, in which said ballast resistors (26b) are proportioned in relation to each other so that ballast resistances are largest on interior portions of the surface of said semi-conductor body and decrease progressively as a perimeter of said body is approached.

9. A method of designing a transistor (20) for operation at a substantially uniform temperature, said transistor (20) being formed in a semi-conductor body (240) and having an emitter (28), a collector (34) and a base (30), characterised in that said emitter (28) is divided into a plurality of segments (28a,28b) spread substantially uniformly over at least a portion of the body (240) with each emitter segment (28a,28b) having a geometrical shape which provides a ballast resistor (26b) effectively in series with that emitter segment (28a,28b), and said method comprises: measuring the average temperature of the entire transistor (20); and adjusting the value of the resistance of each of the ballast resistors (26b) so that the temperature at each of the respective emitter segments (28a,28b) during operation is substantially equal to said average temperature of the transistor (20).

10. A method of designing a transistor (20) according to claim 9, in which heat dissipation is modelled as an electrical current, temperature is modelled as a voltage, and thermal impedance is modelled as a resistance in parallel with a capacitance.

FIG. 1

FIG. 2

EP 0 413 479 A1

## FIG. 3A

THERMAL SYSTEM

DEVICE TEMPERATURE

HEAT | FLOW

AMBIENT
TEMPERATURE

## FIG. 3B

ELECTRICAL ANALOGUE

DEVICE TEMPERATURE

POWER | RTH | CTH

AMBIENT TEMPERATURE

## FIG. 4A

SILICON DIE

4B

R

H3

4B

H2

H1

R

## FIG. 4B

RTH3X | TI | RTH2X | T2 | RTH1X | T3 | RTH4X

RTH5Z | RTH3Z | RTH2Z | RTH1Z | RTH4Z

## FIG. 5A

(0, 0, 0)

(558, 1136, 330)

## FIG. 5B

RZ1
1.8G

RY1
22

RX1
5.3

RX1B
5.3

RY1B
22

RZ1B
1.86

CTH

## FIG. 6

POS

P → T

R#
1K

POWER

NEG

## FIG. 7

ELECTRICAL

THERMAL

DEVICE TEMPERATURE Td

POS

$I_r$

$+$ R0

$V_r$

$-$

COMP_THERMAL

COMP

$+$

$-$

T

POWER =
$I_r \times V_r$

NEG

AMBIENT TEMPERATURE Ta

## FIG. 8

POS

C   T

B

Q#

P → T

POWER

E

NEG

## FIG. 9

ELECTRICAL

THERMAL

DEVICE TEMPERATURE Td

Ic

C

T

QTHERMAL

B

Vce

COMP

POWER =
Ic x Vce

COMP_THERMAL

E

AMBIENT TEMPERATURE Ta

## FIG. 10

POS

P → T

R#
1K

POWER

NEG

TC

## FIG. 11

ELECTRICAL

THERMAL

DEVICE TEMPERATURE Td

POS

Ir

Vr

RO

COMP_THERMAL

COMP

T

POWER =
Ir x Vr

AMBIENT TEMPERATURE Ta

NEG

T AVG

AVERAGE TEMPERATURE

FIG. 12

ELECTRICAL

THERMAL

EP 0 413 479 A1

FIG. 13

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-2175441 (TEXAS INSTRUMENTS LIMITED) <br> * page 1, lines 99 - 108; claim 2 * | 1-9 | H01L29/73 <br> H01L29/08 |
| Y | | 10 | |
| Y,D | EDN ELECTRICAL DESIGN NEWS. <br> 14 April 1988, NEWTON, MASSACHUSETT <br> pages 169 - 180; E.Filseth et al.: <br> "Spice Extensions Dynamically Model Thermal Properties" <br> * page 170, column 1, lines 7 - 16 * | 10 | |
| A,D | US-A-4072979 (SGS-ATES) <br> * abstract; figure 3 * | 1-8 | |

**TECHNICAL FIELDS SEARCHED (Int. Cl.5 )**

H01L

The present search report has been drawn up for all claims

| Place of search | Date of completion of the search | Examiner |
|---|---|---|
| THE HAGUE | 07 NOVEMBER 1990 | NILES N.P.E. |